# EUROPÄISCHE PATENTSCHRIFT

(11) **EP 3 602 551 B1**
(45) Veröffentlichungstag und Bekanntmachung des Hinweises auf die Patenterteilung: **13.05.2020**
(21) Anmeldenummer: 18710854.3
(22) Anmeldetag: 12.03.2018
(51) Int. Cl.: G10L 21/0364, H04R 1/10, H03G 9/00, G06F 3/16, H04L 12/18, H04L 29/06, H04M 3/56, G10L 19/16, H03G 9/02

(54) **VORRICHTUNG UND VERFAHREN ZUR VERARBEITUNG VON AUDIOSIGNALEN ZUR VERBESSERUNG DER SPRACHVERSTÄNDLICHKEIT**
APPARATUS AND METHOD FOR PROCESSING AUDIO SIGNALS FOR IMPROVING SPEECH INTELLIGIBILITY
DISPOSITIF ET PROCÉDÉ DE TRAITEMENT DE SIGNAUX AUDIO EN VUE D'AMÉLIORER L'INTELLIGIBILITÉ DE LA PAROLE

(30) Priorität: 24.03.2017 DE 102017106359
(43) Veröffentlichungstag der Anmeldung: 05.02.2020
(73) Patentinhaber: Sennheiser electronic GmbH & Co. KG, 30900 Wedemark (DE)
(72) Erfinder: DIAS DE PAIVA, Rafael Cauduro, 30900 Wedemark (DE); VELLAICHAMY, Senthil Kumar, 22880 Wedel (DE)
(74) Vertreter: Eisenführ Speiser
(86) Internationale Anmeldenummer: PCT/EP2018/056011
(87) Internationale Veröffentlichungsnummer: WO 2018/172111

(56) Entgegenhaltungen:
- GB-A- 2 151 870
- US-A- 3 720 788
- US-A- 4 622 692
- US-A- 4 837 832
- US-A1- 2008 069 385
- US-A1- 2008 181 424
- US-A1- 2009 187 400
- US-A1- 2016 021 149
- US-B1- 7 042 986

## Beschreibung

Die Erfindung betrifft eine Vorrichtung zur Verarbeitung von Audiosignalen zur Verbesserung der Sprachverständlichkeit sowie ein entsprechendes Verfahren.

### Hintergrund

Für das Streaming von Audiodaten an mehrere Empfänger gleichzeitig gibt es zahlreiche wichtige Anwendungen. Es kann z.B. in Kinos und Theatern genutzt werden, um spezielle Dialogtonspuren für hörgeschädigte Zuschauer, Tonspuren mit einer Audiobeschreibung für sehbehinderte Menschen im Publikum oder Übersetzungen der Dialoge in andere Sprachen für fremdsprachige Zuschauer zu versenden. Dabei erfolgt die Wiedergabe typischerweise über Kopfhörer oder Ohrhörer. In diesen Fällen wäre es wünschenswert für Betreiber, ein Streaming-System zu haben, das einfach aufgebaut und gewartet werden kann.

Es gibt viele Systeme, mit denen Audiodatenströme an mehrere Nutzer in Kinos, Theatern oder großen Konferenzsälen geschickt werden können, z.B. ADN Wireless oder das TourGuide-System von der Firma Sennheiser. Normalerweise benötigen solche Systeme spezielle Geräte. Andere Ansätze wie Twavox (www.twavox.com), Listen Technologies (www.listentech.com) oder Audio Everywhere (www.audioeverywhere.com) bieten dem Nutzer eine Möglichkeit, Audiodaten auf das eigene Smartphone gesendet zu bekommen.

In allen diesen Fällen ist es jedoch dem einzelnen Nutzer kaum möglich, die Wiedergabequalität der Audiodaten zu beeinflussen. Besonders wenn der Nutzer bestimmte persönliche Präferenzen hat, z. B. wenn individuelle leichte Gehörschädigungen vorhanden sind, wäre es wünschenswert, wenn dem Nutzer eine Möglichkeit zur individuellen Korrektur bzw. Angleichung der Audiodaten bereitgestellt werden könnte. Dabei wäre insbesondere eine Verbesserung von Sprachverständlichkeit vorteilhaft. Diese geht oft auch mit einer angenehmeren Empfindung von Musik einher. Eine einfache Verstärkung der Audiosignale gleichmäßig über alle Frequenzbereiche führt dabei zu einer übermäßigen Gesamtlautstärke, die als störend empfunden wird und auch das Gehör schädiqen kann. Eine Vorrichtung, bei der der Nutzer eine frequenzabhängige Verstärkung steuern kann, ist zum Beispiel in US 2008/0069385 A1 offenbart.

### Zusammenfassung der Erfindung

Eine Aufgabe der vorliegenden Erfindung besteht in der Bereitstellung eines Streaming-Systems mit verbesserter Audioverständlichkeit. Eine weitere Aufgabe besteht darin, dem Nutzer eine Möglichkeit zur individuellen Korrektur bzw. Angleichung der Audiodaten an individuelle Bedürfnisse bereit zu stellen. Insbesondere soll es einem Nutzer mit einer der typischen verbreiteten (ggf. beginnenden) Hörschwächen ermöglicht werden, eine individuell einstellbare Verbesserung von Sprachverständlichkeit zu erreichen.

Diese Aufgaben werden durch eine Vorrichtung gemäß Anspruch 1 gelöst.
Ein entsprechendes Verfahren bzw. Computerprogrammprodukt ist in den Ansprüchen 8 bzw. 12 angegeben. Weitere vorteilhafte Ausführungsformen werden in den Ansprüchen 2 - 7, 9 - 11, 13 und 14 beschrieben. Ein weiterer Vorteil der Erfindung ist, dass diese individuelle Einstellbarkeit über eine einfach und intuitiv zu bedienende Nutzerschnittstelle erreicht wird.

Erfindungsgemäß enthält eine Vorrichtung zur Verarbeitung von Audiosignalen für Kopfhörer- oder Ohrhörerwiedergabe mit einstellbarer Verbesserung der Sprachverständlichkeit eine Filterbank zum Aufspalten eines Eingangssignals in mindestens drei Signalanteile unterschiedlicher Frequenzen, mindestens drei individuell einstellbare Audiokompressoren, die mit der Filterbank verbunden sind, um jeweils einen der Signalanteile von der Filterbank zu verarbeiten, eine Summationseinheit zum Aufsummieren der Ausgangssignale der Audiokompressoren, wobei ein Ausgangssignal mit verbesserter Sprachverständlichkeit erzeugt wird, und eine Nutzerschnittstelle (User Interface, UI) zur Eingabe von mindestens zwei unabhängigen Parametern. Dabei wirkt ein Parameter auf das Gesamtsignal und steuert eine Gesamtlautstärke des Ausgangssignals. Der zweite Parameter stellt eine Verbesserung der Sprachverständlichkeit ein, indem eine Erhöhung des zweiten Parameters bei dem Kompressor für hohe Frequenzen den Verstärkungsgrad für Audiosignale mit geringem Lautstärkepegel stärker erhöht als den Verstärkungsgrad für Audiosignale mit mittlerem oder hohem Lautstärkepegel und zusätzlich die Verstärkung des Kompressors für tiefe Frequenzen reduziert wird, so dass mit Anstieg des zweiten Parameters die tiefen Frequenzen zunehmend gedämpft werden.

Ein erfindungsgemäßes Verfahren zur Verarbeitung von Audiosignalen für Kopfhörer- oder Ohrhörerwiedergabe mit einstellbarer Verbesserung der Sprachverständlichkeit enthält die Schritte Einlesen von mindestens zwei unabhängig einstellbaren Parametern von einer Nutzerschnittstelle, Aufspalten eines Eingangsaudiosignals in mindestens je ein Frequenzband für tiefe, mittlere und hohe hörbare Frequenzen, Korrigieren der Lautstärkepegel jedes Frequenzbandes mit mindestens drei individuell einstellbaren Audiokompressoren, die hohe Eingangspegel oberhalb eines Schwellenwertes ihres jeweiligen Frequenzbandes auf ein Maximum begrenzen und geringere Eingangspegel unterhalb des Schwellenwertes ihres jeweiligen Frequenzbandes individuell verstärken, dämpfen oder unverändert lassen, und Aufsummieren der Ausgangssignale der Audiokompressoren, wobei ein Ausgangssignal mit verbesserter Sprachverständlichkeit erzeugt wird. Dabei steuert einer der mindestens zwei unabhängig einstellbaren Parameter eine Gesamtlautstärke des Ausgangssignals. Der zweite Parameter stellt die Verbesserung der Sprachverständlichkeit ein, indem er durch Anstieg des zweiten Parameters bei dem Kompressor für hohe Frequenzen den Verstärkungsgrad für Audiosignale mit geringem Lautstärkepegel stärker erhöht als den Verstärkungsgrad für Audiosignale mit mittlerem oder hohem Lautstärkepegel und zusätzlich die Verstärkung des Kompressors für tiefe Frequenzen reduziert wird, so dass mit Anstieg des zweiten Parameters die tiefen Frequenzen zunehmend gedämpft werden.

### Kurze Beschreibung der Zeichnungen

Weitere Einzelheiten und vorteilhafte Ausführungsformen sind in den Zeichnungen dargestellt, die in der detaillierten Beschreibung unten näher erläutert werden. Darin zeigt
- Fig. 1: einen Überblick über ein Audiostreaming-System;
- Fig. 2: eine beispielhafte 2D-Nutzerschnittstelle gemäß einer Ausführungsform;
- Fig. 3: die Struktur einer Vorrichtung gemäß einer Ausführungsform;
- Fig. 4: eine grundsätzliche Kennlinie eines Audiokompressors;
- Fig. 5: die frequenzabhängige Wirkung des zweiten Parameters auf die Verstärkung der Kompressoren;
- Fig. 6: die prinzipielle Wirkung des zweiten Parameters auf einen vorgeschalteten Equalizer;
- Fig. 7: ein Audiostreaming-System gemäß einer Ausführungsform;
- Fig. 8: ein Beispiel einer vorteilhaften Implementierung der Vorrichtung;
- Fig. 9: zentrale Kontrolle über angeschlossene Mikrofone; und
- Fig. 10: eine exemplarische Positionierung von Audioquellen im Raum.

### Detaillierte Beschreibung der Erfindung

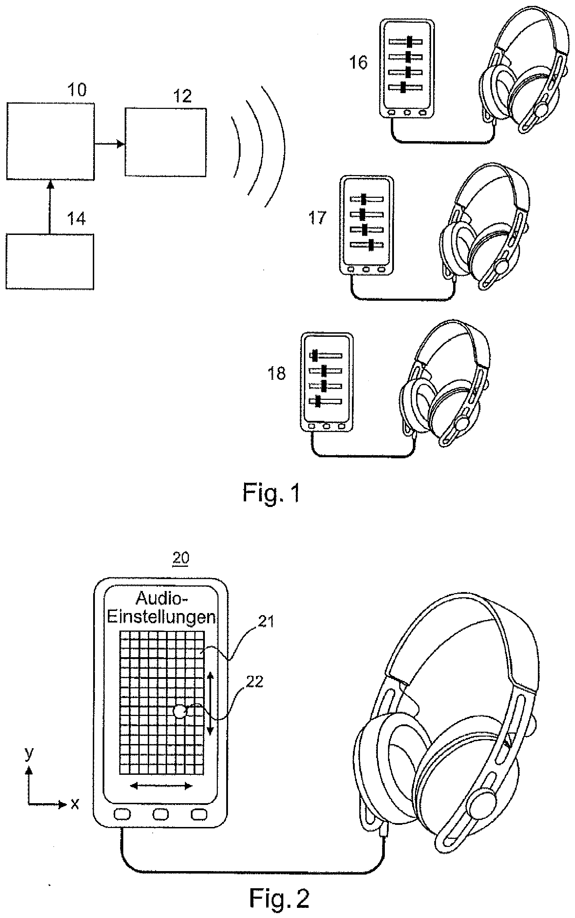

Fig. 1 zeigt einen Überblick über ein erfindungsgemäßes Audiostreaming-System. Audiodaten kommen von einer oder mehreren Quellen 14 und werden vom Audiostreamer 10 an Terminals 16, 17, 18 verteilt, an denen Zuhörer z.B. über Kopfhörer zuhören können. Dabei kann vorteilhafterweise ein existierendes Netzwerk 12 wie WiFi (WLAN, IEEE 802.11) mit Standardkomponenten benutzt werden. Auch können die Terminals 16 - 18 dann normale Smartphones sein, und die Zuhörer können ihre eigenen (Standard-) Kopfhörer benutzen. Dies reduziert nicht nur Kosten für Kinos oder Theater, weil keine speziellen Geräte für jeden Zuschauer angeschafft und gewartet werden müssen, sondern erlaubt auch eine erhöhte Akzeptanz im Publikum, weil jeder Zuschauer/Zuhörer sein eigenes Gerät benutzen kann, mit dem er sich auskennt. Zusätzlich wird den Zuhörern erfindungsgemäß eine Möglichkeit gegeben, die Wiedergabe entsprechend einer individuellen Hörcharakteristik oder Vorliebe bzw. auch einer individuellen Hörschwäche anzupassen. Diese Möglichkeit zur Anpassung kann auch bei der Benutzung bestimmter Kopfhörer vorteilhaft sein, die sich von anderen unterscheiden.

An den Audiostreamer 10 können unterschiedliche Quellen 14 angeschlossen werden, z.B. ein Server im Kino, verschiedene Audiowiedergabegeräte oder Mikrofone. Es ist auch möglich, das Netzwerk mit üblichen Smartphones und daran angeschlossenen Mikrofonen zu benutzen, wie weiter unten beschrieben wird. Die Terminals 16-18 sind in dem in Fig. 1 gezeigten Beispiel Smartphones mit einem speziellen Software-Programm ("App"). Das Programm erlaubt eine individuelle Audiosignalverarbeitung, die der Nutzer mit Hilfe des berührungsempfindlichen Bildschirms (Touchscreen) steuern kann. Dabei können erfindungsgemäß mindestens zwei Parameter eingestellt werden, die mindestens drei individuell einstellbare Audiokompressoren steuern. Das Smartphone und das auf dessen Prozessor ausgeführte Programm stellen somit eine Vorrichtung zur Verarbeitung von Audiosignalen mit einstellbarer Verbesserung der Sprachverständlichkeit dar. Diese Vorrichtung enthält eine Filterbank zum Aufspalten des Eingangsaudiosignals in mindestens drei Frequenzbänder, die bereits erwähnten mindestens drei individuell einstellbaren Audiokompressoren, die jeweils einen der Signalanteile von der Filterbank verarbeiten, eine Summationseinheit zum Aufsummieren der Ausgangssignale der Audiokompressoren, und eine Nutzerschnittstelle zum Einstellen von mindestens zwei Parametern unabhängig voneinander.

Die Nutzerschnittstelle kann z.B. (virtuelle) Schieberegler enthalten, wie in Fig. 1 angedeutet. Besser ist jedoch eine Fig. 2 beispielhaft gezeigte 2D-Nutzerschnittstelle gemäß einer Ausführungsform. Hier sind die beiden Parameter der Hoch- bzw. Rechtsachse eines Eingabefeldes 21 auf dem Touchscreen zugeordnet. Der Nutzer kann durch Wahl eines Punktes 22 auf dem Eingabefeld beide Parameter gleichzeitig setzen und durch Bewegung des Fingers über das Eingabefeld die Parameter verändern und gleichzeitig hören, wie sich die Veränderung der Parameter auswirkt. Dabei steuert einer der Parameter die Gesamtlautstärke des Ausgangssignals, z.B. die Position auf der Hochachse y. Der zweite Parameter, z.B. die Position auf der Rechtsachse x, steuert die Verbesserung der Sprachverständlichkeit. Wenn zur Verbesserung der Sprachverständlichkeit eine weiter rechts gelegene Position gewählt wird, führt der entsprechende Wert des zweiten Parameters dazu, dass bei dem Audiokompressor für hohe Frequenzen der Verstärkungsgrad für Audiosignale mit geringem Lautstärkepegel überproportional stärker erhöht wird. Insbesondere wird der Verstärkungsgrad für höherfrequente Audiosignale mit geringem Lautstärkepegel stärker erhöht als der Verstärkungsgrad für höherfrequente Audiosignale mit mittlerem oder hohem Lautstärkepegel. Zusätzlich kann der Wert des zweiten Parameters auch einen vorgeschalteten Equalizer steuern. Außerdem können zur Verbesserung der Sprachverständlichkeit mit dem zweiten Parameter auch die Verstärkungen der anderen Kompressoren geändert werden. Gemäß der Erfindung wird die Verstärkung des Kompressors für tiefe Frequenzen reduziert, so dass die tiefen Frequenzen zunehmend gedämpft werden. Weitere Einzelheiten dazu werden weiter unten erläutert.

In einem Ausführungsbeispiel können auch weitere Parameter über die Nutzerschnittstelle eingegeben werden, z.B. zur Einstellung einer empfundenen Wiedergabelautheit, zur Einstellung eines Equalizers, Mischers oder Kompressors, oder zur Auswahl spezieller Filter, die die Sprachverständlichkeit erhöhen oder an spezielle Hörschädigungen angepasst sind oder gewünschte spezifische Frequenzantworten haben. Die individuell gewählten Parameter werden gespeichert, z.B. unmittelbar und/oder beim Abschalten der Vorrichtung.

Wenn der Zuhörer den Audiostream über sein Terminal 16 - 18 empfängt und wiedergibt, kann er eine individuelle Frequenzcharakteristik zur Wiedergabe über sein Terminal 16-18 einstellen. In einer Ausführungsform ist es auch möglich, eine individuelle Frequenzcharakteristik zur Wiedergabe an Hand eines Kontrollsignals vorab einzustellen und die charakteristischen Parameter zu speichern. Wenn Audiosignale von einer anderen Quelle eine Frequenzcharakteristik haben, die von der Frequenzcharakteristik des Kontrollsignals deutlich abweicht, wird in dieser Ausführungsform automatisch eine aktuelle individuelle Frequenzcharakteristik erzeugt, indem die Frequenzcharakteristik der Quelle an die Frequenzcharakteristik des Kontrollsignals angepasst wird. Dazu werden bei einer Analyse Energieinhalte von definierten Frequenzbändern des Eingangssignals bestimmt und durch adaptives Verstärken oder Dämpfen an die Energieinhalte der entsprechenden Frequenzbänder des Kontrollsignals angeglichen. Dann kann die vorher eingestellte individuelle Frequenzcharakteristik entsprechend der charakteristischen Parameter auch für das abweichende Eingangssignal wieder erreicht werden.

Die oben beschriebenen Ausführungsbeispiele der Vorrichtung können teilweise oder vollständig als programmgesteuerter Computer, aber auch mit anderen, spezifischen Hardware-Komponenten für einige oder alle Blöcke ausgeführt sein.

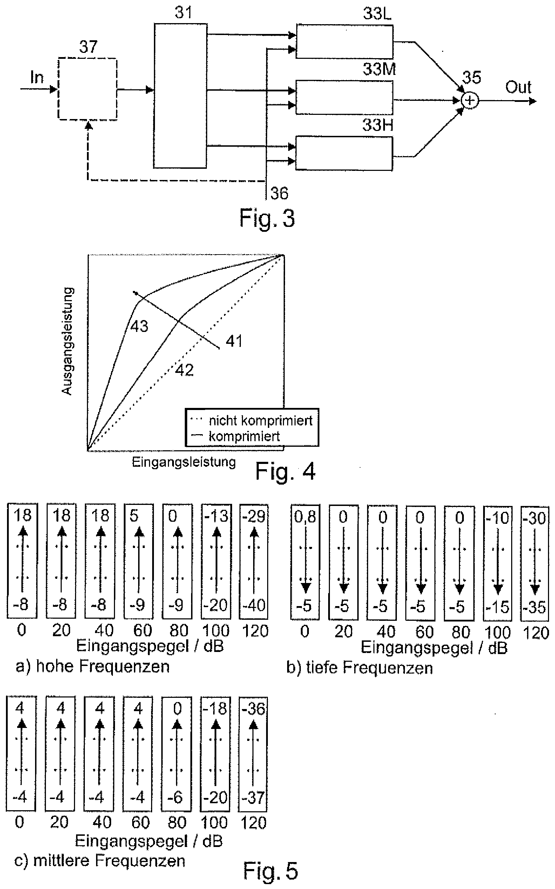

Fig. 3 zeigt die Struktur einer erfindungsgemäßen Vorrichtung gemäß einer Ausführungsform. Ein Eingangssignal wird in eine z.B. 3-Band-Filterbank 31 gegeben, die es in drei Frequenzbänder spaltet, mit jeweils einem Frequenzband für Signalanteile tiefer, mittlerer und hoher hörbarer Frequenzen. Dabei kann ein Übergang von den tiefen zu den mittleren hörbaren Frequenzen z.B. im Bereich von 600 - 1000 Hz und ein Übergang von den mittleren zu den hohen hörbaren Frequenzen z.B. im Bereich von 3000 - 5000 Hz liegen. In anderen Ausführungsformen kann jedes der Frequenzbänder noch weiter unterteilt sein. Jedes der Frequenzbänder wird in einen adaptiven Audiokompressor 33L, 33M, 33H gegeben. Die adaptiven Audiokompressoren oder Dynamikkompressoren werden mit Hilfe eines aus dem zweiten Parameter abgeleiteten Steuersignals 36 adaptiert. Besonders vorteilhaft ist es, wenn die Filterbank 31 phasenlinear arbeitet bzw. die darin enthaltenen Filter identische Phasenverläufe haben, so dass die in den Kompressoren bearbeiteten verschiedenen Frequenzbänder in einer Summationseinheit 35 einfach wieder zusammengefügt werden können. Andernfalls sind Phasenkorrekturen vorzunehmen.

Die Kompressoren 33L für den niederfrequenten Anteil, 33M für den mittelfrequenten Anteil und 33H für den höherfrequenten Anteil des Eingangssignals arbeiten im Prinzip gleich, haben aber individuell unterschiedliche und einstellbare Kennwerte. Jeder der mindestens drei individuell einstellbaren Audiokompressoren, die mit der Filterbank 31 verbunden sind, verarbeitet jeweils eines der Signalanteile aus der Filterbank. Dabei werden Eingangspegel oberhalb eines Schwellwertes des jeweiligen Frequenzbandes auf ein Maximum begrenzt. Diese bei Audiokompressoren übliche Funktionalität wird dadurch erweitert, dass die Audiokompressoren 33L, 33M, 33H auch bei Eingangspegeln unterhalb des Schwellwertes die Ausgangspegel individuell verändern können. Mit anderen Worten, für Signale mit geringerem Eingangspegel können die Audiokompressoren ebenfalls eine Verstärkung oder eine Abschwächung (Dämpfung) erzeugen. Die genauen Werte sind konfigurierbar bzw. programmierbar und hängen vom gewählten Wert des zweiten Parameters ab, da sie Einfluss auf die Sprachverständlichkeit haben.

Fig. 4 zeigt eine vereinfachte grundsätzliche Kennlinie eines der Audiokompressoren 33L, 33M, 33H. Je nach Einstellung eines Steuerparameters 41 werden Eingangssignale entweder linear verstärkt 42, oder geringe Eingangspegel werden zunehmend stärker verstärkt als höhere Eingangspegel 43. Hohe Eingangspegel werden aber gedämpft, so dass der Dynamikbereich insgesamt unverändert bleiben kann. Leise Töne werden aber besonders angehoben und daher besser hörbar. Die Kennlinie ist mindestens insofern vereinfacht, dass die Kurve nur einen "Knick" hat. In Implementierungen hat die Kurve meist mehrere "Knicke" bzw. Wendepunkte.

Die Filterbank 31 spaltet das Eingangsaudiosignal in mindestens drei Frequenzbänder, mit mindestens jeweils einem Frequenzband für Signalanteile tiefer, mittlerer und hoher Frequenzen. Die Signalanteile jedes dieser Frequenzbänder werden von adaptiven Kompressoren weiterverarbeitet, die zusätzlich eine durch den zweiten Parameter veränderbare Verstärkungs- bzw. Dämpfungsfunktion haben.

Fig. 5 zeigt die Wirkung des zweiten Parameters auf die Verstärkung bzw. Dämpfung der adaptive Audiokompressoren 33L, 33M, 33H. Die Zahlenwerte bedeuten einen Unterschied zwischen Eingang- und Ausgangspegel des Kompressors in Dezibel, z.B. bedeutet ein Wert von -8 bei einem Eingangspegel von 40 dB einen Ausgangspegel von 32 dB. Die Pfeile deuten die Wirkung einer Änderung des zweiten Parameters in Richtung verbesserter Sprachverständlichkeit an. Dabei ist klar, dass eine Einstellung des zweiten Parameters auf einen Maximalwert bzw. auf "maximale Sprachverständlichkeit" nicht unbedingt eine optimale Sprachverständlichkeit für alle Nutzer bedeutet, da die Abweichungen der Hörcharakteristiken individuell sind. Der Begriff "maximale Sprachverständlichkeit" ist in diesem Zusammenhang eher als maximale Abweichung von einer Normkurve für "normales" Hörempfinden zu verstehen. Daher kann eine Einstellung des zweiten Parameters auf einen Maximalwert z.B. von Nutzern mit empfindlichem gesundem Gehör als unangenehm empfunden werden. Ebenso ist der Minimalwert des zweiten Parameters kein neutraler Wert, sondern der vom zweiten Parameter abgedeckte Bereich weicht in verschiedene Richtungen vom Neutralwert ab. Demzufolge lässt sich ein neutraler Wert für den zweiten Parameter in einem mittleren Bereich - nicht unbedingt exakt mittig - einstellen. Wie oben beschrieben, können Nutzer individuelle Lieblingseinstellungen wählen, womit sie auch implizit den zweiten Parameter festlegen. Im Folgenden wird angenommen, dass die Wahl einer höheren bzw. besseren Sprachverständlichkeit einer Steigung des zweiten Parameters entspricht. Dieser Zusammenhang ist jedoch nicht nur individuell unterschiedlich, sondern kann jedoch auch anders implementiert sein (z.B. als Senkung des zweiten Parameters).

Die in Fig. 5a) dargestellte exemplarische Charakteristik des Kompressors 33H für hohe Frequenzen zeigt, dass mit einer Steigerung des zweiten Parameters der Verstärkungsgrad für Audiosignale mit geringem Lautstärkepegel stärker erhöht wird als der Verstärkungsgrad für Audiosignale mit mittlerem oder hohem Lautstärkepegel. Z.B. wird für das hochfrequente Band von Eingangssignalen mit einem Eingangspegel von 0 dB über 20 dB bis 40 dB eine Verstärkung eingestellt, die zwischen -8 dB (Dämpfung) und +18 dB (Verstärkung) gemäß dem zweiten Parameter ansteigt, Für das hochfrequente Band von Eingangssignalen mit einem Eingangspegel von 60 dB wird dagegen eine Verstärkung gewählt, die gemäß dem zweiten Parameter nur zwischen -9 dB (Dämpfung) und +5 dB (Verstärkung) ansteigt. Dabei kann sich die Verstärkung/Dämpfung innerhalb des angegebenen Bereiches ganz oder teilweise (annähernd) linear mit dem zweiten Parameter ändern, muss es aber nicht. Für andere, zwischen den angegebenen Werten liegende Eingangspegel (z.B. 50 dB) kann ebenfalls linear interpoliert werden. Bei ca. 80 dB beginnt die andere oben beschriebene Funktion des Kompressors einzugreifen, indem der Ausgangspegel zunehmend gegenüber dem Eingangspegel reduziert wird. Dies entspricht einer Begrenzung des maximalen Schalldrucks, um das Gehör zu schützen. Dieser Schwellwert kann z.B. im Bereich 75-85 dB liegen.

Fig. 5b) zeigt exemplarisch eine Charakteristik des Kompressors 33L für tiefe Frequenzen. Hier werden mit Anstieg des zweiten Parameters die Verstärkungen für alle Eingangspegel reduziert. Nur bei sehr geringem Eingangspegel von 0 dB erfolgt bei niedrig eingestelltem zweitem Parameter eine geringe Verstärkung. Außerdem erfolgt wieder die für Kompressoren typische starke Dämpfung oberhalb von 80 dB. Davon abgesehen ist jedoch der Einfluss des zweiten Parameters auf die Verstärkung/Dämpfung deutlich geringer als beim Kompressor 33H für hohe Frequenzen.

Fig. 5c) zeigt exemplarisch eine Charakteristik des Kompressors 33M für mittlere Frequenzen. Mit Anstieg des zweiten Parameters werden die Verstärkungen für alle Eingangspegel leicht erhöht. Auch hier erfolgt die für Kompressoren typische starke Dämpfung oberhalb von 80 dB, und der Einfluss des zweiten Parameters auf die Verstärkung/ Dämpfung ist deutlich geringer als beim Kompressor 33H für hohe Frequenzen. Auch für tiefe und mittlere Frequenzen kann sich die Verstärkung/Dämpfung des jeweiligen Kompressors innerhalb des angegebenen Bereiches ganz oder teilweise (annähernd) linear mit dem zweiten Parameter ändern.

In einer Ausführungsform liegt der Schwellwert für hohe Eingangspegel bei ca. 75 - 80 dB und bei höheren Eingangspegeln das Maximum der Ausgangswerte bei ca. 80 - 100 dB.

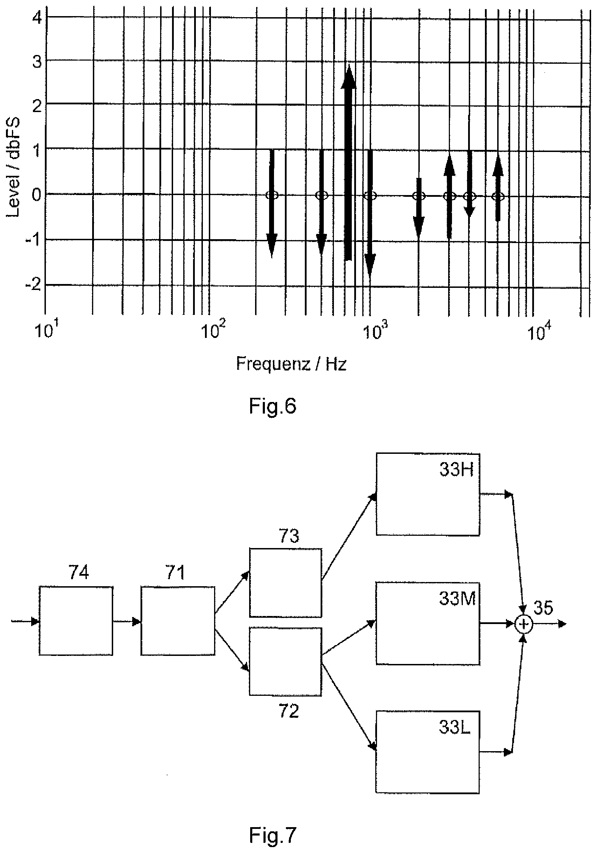

In einer Ausführungsform wird der Filterbank 31 optional ein Equalizer 37 vorgeschaltet. Dieser wird ebenfalls durch ein aus den zweiten Parameter abgeleitetes Steuersignal 36 gesteuert. Fig. 6 zeigt die prinzipielle Wirkung des zweiten Parameters auf einen vorgeschalteten Equalizer. Wieder deuten die Pfeile frequenzabhängige Verstärkungs- bzw. Dämpfungswerte in Abhängigkeit vom zweiten Parameter an, die jedoch pegelunabhängig sind. Der zweite Parameter wird angenommen wie oben beschrieben, d.h. mit steigendem Wert hin zu höherer bzw. besserer Sprachverständlichkeit. Mit dem Equalizer 37 können im Bereich von ca. 500 - 6000 Hz schmale Frequenzbänder (von z.B. 30 - 300Hz Breite) gezielt um bis zu 3 dB verstärkt oder gedämpft werden. Dabei werden zur Verbesserung der Sprachverständlichkeit im Prinzip insbesondere Frequenzbänder im Bereich bis 500 Hz sowie im Bereich 1 kHz mit steigendem Parameter zunehmend gedämpft, und Frequenzbänder im Bereich 700 - 800 Hz mit steigendem Parameter zunehmend besonders verstärkt. Z.B. steuert der zweite Parameter den Equalizer 37, wie in Fig. 6 gezeigt, indem die Verstärkung tiefer Frequenzen unterhalb 500 Hz von ca. +1 dB bis -1.5 dB zunehmend reduziert und gleichzeitig die Verstärkung mittlerer Frequenzen bei 700 - 800 Hz von ca. -1.5 bis 3 dB angehoben wird. Ebenso werden Frequenzen bei ca. 1 kHz, 2 kHz und 4 kHz zunehmend leicht gedämpft, während Frequenzen bei ca. 3 kHz und ab 6 kHz zunehmend leicht verstärkt werden.

Der vorgeschaltete Equalizer 37 bewirkt eine verbesserte Wirkung der Anordnung aus n-Band-Filterbank und n Kompressoren. Im Fall von n>3 kann zwischen den oben angegebenen Werten interpoliert werden, wobei Abweichungen der individuellen Frequenzen feiner ausgeglichen werden können. Die angegebene 3-Band-Architektur liefert jedoch für die meisten Fälle ein gutes Ergebnis. Stärkere Abweichungen der individuellen Hörcharakteristik werden hier nicht betrachtet, denn die Erfindung soll im einfachsten Fall keine medizinisch notwendige Hörhilfe (Hörgerät) ersetzen.

Fig. 7 zeigt ein Beispiel einer vorteilhaften Implementierung der erfindungsgemäßen Vorrichtung zur Verarbeitung von Audiosignalen für Kopfhörer- oder Ohrhörerwiedergabe mit einstellbarer Verbesserung der Sprachverständlichkeit. Insbesondere wird in diesem Beispiel die Filterbank 31 durch zwei einfache Filterbankmodule 71, 72, die in diesem Fall energiekomplementär (power complementary, PC) sind, sowie einen Phasenkorrekturfilter 73 realisiert. Jedes der Filterbankmodule 71, 72 teilt sein Eingangssignal in zwei Frequenzbänder auf, die zusammen dieselbe Energie wie das Eingangssignal aufweisen. Dabei verändern die Filterbankmodule die Phasenlagen der Signale, allerdings gleichmäßig, so dass sich durch einfache Zusammenführung der Ausgangssignale wieder das Eingangssignal ergibt. Daher muss, zum Ausgleich des Phasengangs des zweiten Filterbankmoduls 72, auch das erste Ausgangssignal des ersten Filterbankmoduls 71 einer Phasenkorrektur 73 unterzogen werden, bevor die resultierenden Signale den Kompressoren 33L, 33M, 33H zugeführt werden. Da die Kompressoren i.a. die Phasenlage nicht verändern, kann die Phasenkorrektur 73 im Prinzip auch hinter dem Kompressor 33H erfolgen. Anschließend werden die komprimierten Signale in der oben beschriebenen Summationseinheit 35 wieder zusammengeführt. Ein Vorteil dieser Ausführungsform besteht darin, dass die Filterbank 31 vereinfacht wird und auf Grund des einfachen Aufbaus mit wenig Leistung bzw. im Fall einer Software-basierten Implementierung mit wenig Rechenkapazität auskommt. Dadurch reduzieren sich die Rechenzeit und damit die Latenzzeit des Systems. Ein optionales Klarheitsfilter 74 kann der Filterbank vorgeschaltet werden, um einzelne Frequenzbänder anzuheben und dadurch die Sprachverständlichkeit noch weiter zu verbessern. Dabei kann der Klarheitsfilter 74 ebenso wie die Kompressoren durch den zweiten Parameter modifiziert werden, bzw. der Klarheitsfilter 74 kann auch mit dem oben beschriebenen Equalizer 37 identisch sein. Bei sehr geringen Eingangslautstärken kann eine Rauschunterdrückung (z.B. "noise gate") eingesetzt werden.

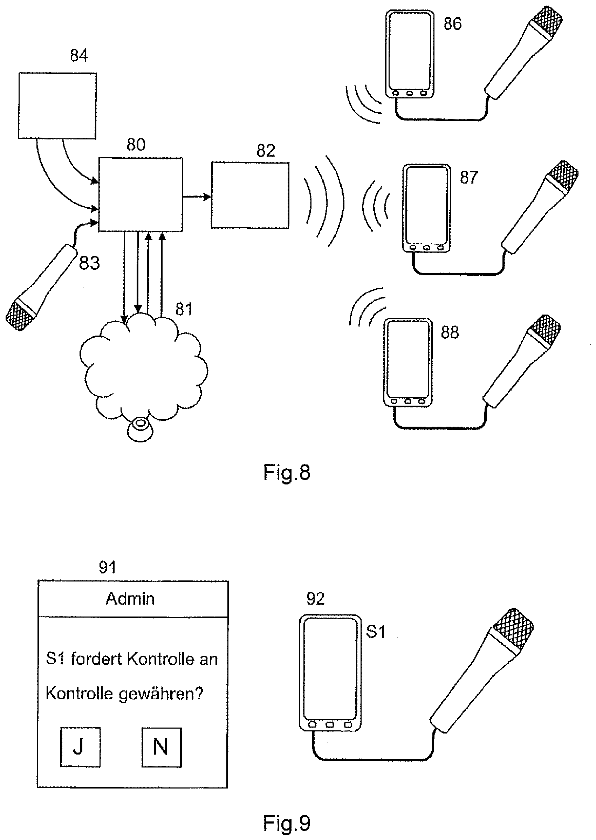

Fig. 8 zeigt ein Audiostreaming-System gemäß einer weiteren Ausführungsform. Es kann vorteilhaft in Lokalitäten wie Konferenzräumen, Hörsälen oder Kinos eingesetzt werden. Das Audiostreamer-System 80 bekommt Eingangssignale von einem Audiowiedergabesystem 84, z.B. einem Kinosystem, einem Mikrofon 83 oder weiteren Mikrofonen, die an Terminals 86-88 von Nutzern angeschlossen und über ein lokales Drahtlos-Netzwerk 82 (z.B. WiFi) mit dem Audiostreamer-System 80 verbunden sind. Außerdem hat das Audiostreamer-System 80 Verbindung mit dem Internet bzw. einem Computerverbund ("Cloud") 81, z.B. um dort die eingehenden Audiosignale vorzugsweise in Echtzeit verarbeiten zu können, Sprachsignale in Text konvertieren zu lassen oder bei einem (Online-) Übersetzungsdienst Sprachsignale übersetzen zu lassen. Das Audiowiedergabesystem 84 kann Sprachsignale in mehreren Sprachen liefern, die durch den zentralen Zugriff auf einen Übersetzungsdienst im Internet bzw. in der Cloud 81 in jede beliebige andere Sprache übersetzt werden können. Daher braucht vorteilhafterweise nicht jedes Terminal 86-88 einzeln auf den Übersetzungsdienst zuzugreifen, wodurch sowohl dieser Dienst als auch der Internetzugang an der jeweiligen Lokalität entlastet wird. Generell benötigen die Terminals 86-88 keinen Internetzugang, sondern nur Zugang zu einem lokalen Netzwerk 82. Die erforderlichen Sprachen der Übersetzung können vorab festgelegt sein und jederzeit geändert werden, z.B. durch Rückmeldung des Nutzers über seine App an das Audiostreamer-System 80. Dieses passt dann die Einstellungen des Übersetzungsdienstes an und kann dann z.B. eine Übersetzung in einer zusätzlichen Sprache auf einem neuen Kanal übertragen. Wie oben beschrieben, können an die Terminals 86-88 der Nutzer auch Kopfhörer angeschlossen sein, worüber die verarbeiteten Audiosignale ausgegeben werden können. Außerdem können die verarbeiteten Audiosignale optional auch über zuschaltbare/abschaltbare Lautsprecher ausgegeben werden.

Das Audiowiedergabesystem 84 kann ein integrierter Block (integrated media block) sein, der mehrere Datenströme gleichzeitig senden und empfangen kann, z.B. Audiodaten und Textdaten. Die Audioquellen können verschiedenen Kanälen zugewiesen werden, denen passende Labels zugeordnet werden und deren Empfang die Nutzer individuell wählen können. Diese Labels werden von einem Systemadministrator ausgewählt und zugeordnet, wobei jeder Kanal Daten einer einzigen Audioquelle oder Daten von einer Mischung verschiedener Audioquellen beinhalten kann. Zum Beispiel definiert der Cinema Server Audio Sources Standard (SMPTE 428-10, 429-12, 430-10, 430-11) 16 Audiokanäle, von denen die linken, mittleren und rechten Kanäle gemischt werden, um eine Audiospur für Hörgeschädigte zu erhalten. Zusätzlich kann eine Audiobeschreibung (narrative track) für Sehgeschädigte in einem anderen Kanal übertragen werden, und zwei gegenwärtig ungenutzte Kanäle können genutzt werden, um Audiodaten in anderen Sprachen bereit zu stellen. Kanäle können physikalische Kanäle (auf verschiedenen Frequenzen) oder logische Kanäle (mit gemeinsamen Frequenzen) sein.

Ein Streaming-Kanal kann auch eine Mischung von Signalen mehrerer Mikrofone enthalten. In einer Ausführungsform der Erfindung wird für diesen Fall eine Strategie zur Kontrolle der Mikrofone bereitgestellt. Demnach wird eine Stimmen-Aktivitätsdetektion (voice activity detection) durchgeführt, um zu entscheiden, welche Mikrofone zeitweilig inaktiv sind und abgeschaltet werden können. Außerdem kann ein zentraler Administrator als Moderator fungieren, um festzulegen, welche oder welches der angeschlossenen Mikrofone aktiv ist. Fig. 9 zeigt eine zentrale Kontrolle über die angeschlossenen Mikrofone für den Moderator. Bei einer Wortmeldung eines Nutzers kann der Administrator über eine Kontrollschnittstelle 91 dem Nutzer Zugang zu einem Ausgabekanal geben, z.B. über ein angeschlossenes Mikrofon 92. Das Mikrofon kann in einem Smartphone, Tablet etc. enthalten oder daran angeschlossen sein.

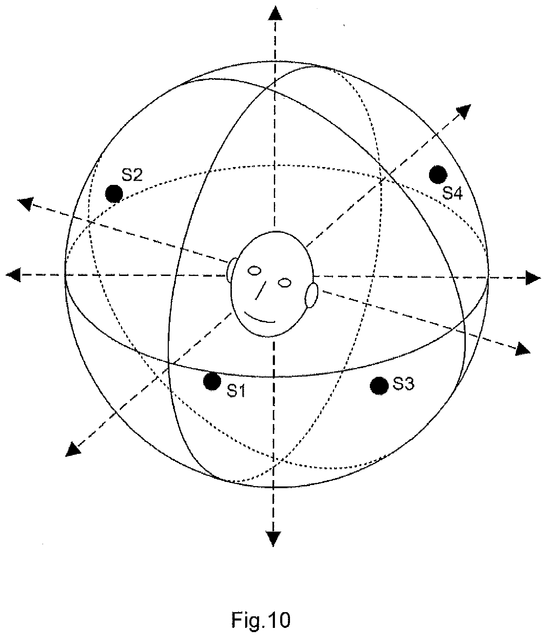

Um mehrere verschiedene beteiligte Quellen voneinander unterscheiden zu können, kann der Administrator die verschiedenen Quellen an unterschiedlichen Positionen im virtuellen Raum anordnen. Dazu werden die Audiodaten jeder Quelle mit entsprechenden Positionsdaten und/oder Verstärkungswerten beaufschlagt, z.B. in einem Stereosignal auf bestimmte Positionen wie rechts/mittig/links gelegt. Die Audiodaten können auch mit Hilfe von kopfbezogenen Übertragungsfunktionen (head-related transfer functions, HRTF) an verschiedenen virtuellen räumlichen Positionen angeordnet werden. Fig. 10 zeigt eine exemplarische Positionierung von Audioquellen S1,..., S4 im Raum, relativ zu einem Nutzer. Die entsprechende Audio-Signalverarbeitung kann lokal oder durch einen Cloud-Service geschehen, wie schon oben erwähnt.

Mit dem erfindungsgemäßen Audiostreaming-System ist es in einer Ausführungsform möglich, über allgemein übliche Netzwerke, wie WiFi, LTE oder ähnlich, Audiodaten an mehrere Teilnehmer zu senden, die z.B. normale Standard-Smartphones mit Netzwerkzugang benutzen, wenn auf den Smartphones ein entsprechendes Programm (App) installiert ist. Die Audiowiedergabe sollte über Kopfhörer oder Ohrhörer erfolgen. Jeder Teilnehmer kann individuell zwischen mehreren Kanälen mit verschiedenen Inhalten wählen. Jeder Teilnehmer kann über das Programm auch seine individuellen Audio-Wiedergabecharakteristika ändern, wie oben beschrieben. Dabei können unterschiedliche (Vor-)Einstellungen der Kompressoren und/oder Equalizer für unterschiedliche Sprachen genutzt und mittels einer Sprachkennung automatisch ausgewählt werden. Die Audiodaten der Kanäle können von mehreren verschiedenen Quellen stammen, darunter auch Kinoserver oder Mikrofone. Diese Mikrofone können sich auch in den Smartphones der Teilnehmer befinden und per Uplink an das Audiostreaming-System gesendet werden. Die Audiodaten der Kanäle können Mischungen von mehreren Audioquellen sein. Das Audiostreaming-System kann eine Kontrolleinheit enthalten, um zu steuern, weiche Quellen aktiv sind.

In einer Ausführungsform betrifft die Erfindung ein Verfahren zur Übertragung von Audiodaten. Das Verfahren kann z.B. benutzt werden, um in einem Konferenzsaal mehreren oder allen Teilnehmern die Möglichkeit zu geben, ihr Smartphone sowohl als persönlichen Audioempfänger als auch als mobiles Mikrofon zu nutzen. Jeder Teilnehmer kann eine Freischaltung seines Mikrofons für einen Redebeitrag anfordern. Ein Moderator wählt eines von potenziell mehreren Smartphones aus, für die eine Freischaltung des Mikrofons angefordert wurde. Insoweit ähnelt das Verfahren einem aus US 9,232,307 B2 bekannten Verfahren, Jedoch wird erfindungsgemäß das Sprachsignal von dem Mikrofon des ausgewählten Smartphones dann über das Internet an einen Dienst zur Verarbeitung des Audiosignals geschickt, z.B. einen Übersetzungsdienst, ein verarbeitetes (z.B. übersetztes) Audiosignal wird von dem Dienst über das Internet empfangen, und das Sprachsignal sowie das von dem Dienst empfangene Audiosignal werden über verschiedene Kanäle des lokalen Netzes an die Teilnehmer gesendet. Dabei ist der Inhalt des von dem Dienst empfangenen Audiosignals gegenüber dem Eingangssignal notwendigerweise um bis zu einige Sekunden verzögert - je nach Art der Verarbeitung. Eine solche Verzögerung ist jedoch unvermeidlich; sie würde auch z.B. bei einem menschlichen Übersetzer auftreten. Jeder Teilnehmer kann einen im lokalen drahtlosen Netz übertragenen Kanal und damit eine verarbeitete oder unverarbeitete Version für sich auswählen, um sie anzuhören. Dementsprechend enthält das Verfahren in einer Ausführungsform die Schritte Einspeisen von Audiosignalen von mindestens zwei Terminals 86 - 88 in ein Audiostreaming-System 80, wobei die Terminals 86-88 über ein drahtloses lokales Netzwerk 82 mit dem Audiostreaming-System 80 verbunden sind, Auswählen eines Audiosignals eines Terminals als Audioquelle, was automatisch oder durch einen Moderator/Regisseur erfolgen kann, Übertragen des ausgewählten Audiosignals vom Audiostreaming-System 80 über das Internet an einen Dienst zur Verarbeitung des Audiosignals, Empfangen eines verarbeiteten Audiosignals von dem Dienst über das Internet, und Aussenden des ausgewählten Audiosignals und des verarbeiteten Audiosignals auf unterschiedlichen Kanälen über das drahtlose lokale Netzwerk 82 an die mindestens zwei Terminals 86 - 88 sowie an mindestens ein drittes Terminal. Die Terminals können somit jeweils als ausgewählte Audioquelle, als wartende (nicht ausgewählte) potenzielle Audioquelle und/oder als reine Audiosenke dienen, und sie können zwischen diesen Rollen wechseln.

In einer Ausführungsform empfängt mindestens ein mit dem drahtlosen lokalen Netzwerk 82 verbundenes Terminal 86 - 88 die ausgesendeten Audiodaten, verarbeitet diese und gibt sie dann wieder, wobei die Verarbeitung ein Aufspalten des Audiosignals in mindestens drei Frequenzbänder mit einer Filterbank und eine Korrektur jedes der Frequenzbänder mit individuell einstellbaren Kompressoren umfasst, und wobei eine Konfiguration der Filterbank und/oder der Kompressoren mit einem 2-dimensionalen Bedienfeld des jeweiligen Terminals gesteuert wird, das z.B. auf dem Touchscreen eines Smartphones dargestellt wird. Dabei dienen eine Dimension des Bedienfelds/Touchscreens einer Lautstärkeeinstellung und die andere Dimension der Konfiguration, so dass beide gleichzeitig vom Nutzer verändert werden können.

In einer Ausführungsform empfangen mindestens zwei Terminals, die mit dem drahtlosen lokalen Netzwerk verbunden sind, die ausgesendeten Audiodaten, wobei an jedem der Terminals individuell mindestens ein Kanal ausgewählt wird.

In einer Ausführungsform kann ein Nutzer an jedem mit dem drahtlosen lokalen Netzwerk verbundenen Terminal einen von mehreren übertragenen Kanälen zur Wiedergabe auswählen.

Der Dienst kann z.B. ein Übersetzungsdienst, ein Sprach-Anonymisierungsdienst oder ein Dienst für eine andere Form der Sprachverarbeitung sein. In einer Ausführungsform ist der Dienst ein Übersetzungsdienst und die verarbeiteten Audiodaten stellen eine Übersetzung der Audiodaten in eine andere Sprache dar.

In einem Aspekt betrifft die Erfindung ein Mehrkanal-Audiostreaming-System mit mindestens einer Audioquelle, einer Audiostreaming-Einheit, mindestens einem Accesspoint 82 für ein Drahtlosnetzwerk und einer Mehrzahl von Empfangsterminals 86-88, wobei die Audiostreaming-Einheit 80 mit einem externen Netzwerk, z.B. einer Cloud oder dem Internet, verbunden ist und darüber Dienste wie z.B. Echtzeit- oder Online-Dienste benutzen kann. Dabei ist jedes der Empfangsterminals dazu ausgestaltet, mehrere Streams von der Audiostreaming-Einheit zu empfangen, und ein Nutzer des Terminals kann einen oder mehrere davon auswählen. In einer Ausführungsform können mehrere oder alle Empfangsterminals je ein Mikrofon enthalten und ein Moderator kann über ein Interface kontrollieren, ob die Audioquelle ein Terminalmikrofon eines Nutzers oder eine andere Quelle, z.B. sein eigenes Mikrofon, ist. In einer anderen Ausführungsform ist die Audioquelle z.B. ein Kinoserver, und die Terminals empfangen nur, ohne zu senden. Ein Vorteil dieses Mehrkanal-Audiostreaming-Systems ist, dass existierende WLAN-Technologie und Infrastruktur benutzt werden können und es verbesserte persönliche Einstellungsmöglichkeiten gibt, z.B. Sprache oder Sprachqualität. Dabei kann jeder Nutzer sein persönliches Gerät benutzen, was unter der Bezeichnung "bring your own device" (BYOD) bekannt ist.

Die Erfindung kann z.B. für Streaming-Systeme in Kinos, Konferenzräumen, Hörsälen oder anderen Veranstaltungsräumen, öffentlichen Plätzen oder im privaten Umfeld verwendet werden.

## Patentansprüche

1. Vorrichtung zur Verarbeitung von Audiosignalen für Kopfhörer- oder Ohrhörerwiedergabe mit einstellbarer Verbesserung der Sprachverständlichkeit, enthaltend
- eine Filterbank (31) zum Aufspalten eines Eingangsaudiosignals (In) in mindestens drei Frequenzbänder, mit jeweils einem Frequenzband für Signalanteile tiefer, mittlerer und hoher hörbarer Frequenzen;
- mindestens drei individuell einstellbare Audiokompressoren (33L, 33M, 33H), die mit der Filterbank verbunden sind, um jeweils einen der Signalanteile von der Filterbank zu verarbeiten, wobei hohe Eingangspegel oberhalb eines Schwellwertes ihres jeweiligen Frequenzbandes auf ein Maximum begrenzt werden;
- eine Summationseinheit (35) zum Aufsummieren von Ausgangssignalen der Audiokompressoren (33L, 33M, 33H), wobei ein Ausgangssignal (Out) mit verbesserter Sprachverständlichkeit erzeugt wird; und
- eine Nutzerschnittstelle mit mindestens zwei unabhängig einstellbaren Parametern,
wobei ein Parameter eine Gesamtlautstärke des Ausgangssignals steuert und der zweite Parameter die Verbesserung der Sprachverständlichkeit steuert, indem zur Verbesserung der Sprachverständlichkeit durch Anstieg des zweiten Parameters bei dem Audiokompressor für hohe Frequenzen (33H) ein Verstärkungsgrad für Audiosignale mit geringem Lautstärkepegel stärker erhöht wird als ein Verstärkungsgrad für Audiosignale mit mittlerem oder hohem Lautstärkepegel, **dadurch gekennzeichnet, dass** zusätzlich eine Verstärkung des Audiokompressors für tiefe Frequenzen (33L) reduziert wird, so dass mit Anstieg des zweiten Parameters die tiefen Frequenzen zunehmend gedämpft werden.

2. Die Vorrichtung gemäß Anspruch 1, wobei der zweite Parameter für jeden der Kompressoren eine von mehreren Kompressorkennlinien auswählt, die sich vorwiegend in der Verstärkung von Audiosignalen mit geringem Pegel unterscheiden.

3. Die Vorrichtung gemäß Anspruch 1 oder 2, wobei ein Übergang von den tiefen zu den mittleren hörbaren Frequenzen im Bereich von 600 - 1000 Hz und ein Übergang von den mittleren zu den hohen hörbaren Frequenzen im Bereich von 3000 - 5000 Hz liegt.

4. Die Vorrichtung gemäß Anspruch 3, wobei der Übergang von den tiefen zu den mittleren hörbaren Frequenzen im Bereich von 900 Hz und der Übergang von den mittleren zu den hohen hörbaren Frequenzen im Bereich von 3500 Hz liegt.

5. Die Vorrichtung gemäß einem der Ansprüche 1 bis 4, wobei die Nutzerschnittstelle ein 2-dimensionales Bedienfeld (21) umfasst, dessen Achsen die zwei unabhängig einstellbaren Parameter sind.

6. Die Vorrichtung gemäß einem der Ansprüche 1 bis 5, weiterhin enthaltend
- einen Speicher zum Speichern von Parametern, die für ein bekanntes Kontrollsignal eingestellt wurden, für das Energieinhalte definierter Frequenzbänder bekannt sind;
- einen Analyseblock zum Analysieren eines Eingangssignals, wobei Energieinhalte der definierten Frequenzbänder des Eingangssignals bestimmt werden; und
- einen Equalizer zum Anpassen des Eingangssignals durch adaptives Verstärken oder Dämpfen der definierten Frequenzbänder entsprechend dem Kontrollsignal, wobei das angepasste Eingangssignal in die Filterbank zum Aufspalten eines Eingangsaudiosignals in mindestens drei Frequenzbänder gegeben wird.

7. Die Vorrichtung gemäß einem der Ansprüche 1 bis 6, weiterhin enthaltend einen vorgeschalteten einstellbaren Equalizer (37), der ebenfalls über den zweiten Parameter gesteuert wird und mit dem im Bereich von ca. 500 - 6000 Hz schmale Frequenzbänder gezielt um bis zu 3 dB verstärkt oder gedämpft werden können, wobei zur Verbesserung der Sprachverständlichkeit Frequenzbänder im Bereich bis 500 Hz gedämpft und Frequenzbänder im Bereich 700 - 800 Hz besonders verstärkt werden.

8. Verfahren zur Verarbeitung von Audiosignalen für Kopfhörer- oder Ohrhörerwiedergabe mit einstellbarer Verbesserung der Sprachverständlichkeit, mit den Schritten
- Erhalten von mindestens zwei unabhängig einstellbaren Parametern von einer Nutzerschnittstelle;
- Aufspalten eines Eingangsaudiosignals in mindestens drei Frequenzbänder mit einer Filterbank, wobei ein erstes Frequenzband Signalanteile niedriger Frequenzen enthält, ein zweites Frequenzband Signalanteile mittlerer Frequenzen enthält und ein drittes Frequenzband Signalanteile hoher Frequenzen enthält;
- Korrigieren der Pegel jedes Frequenzbandes mit mindestens drei individuell einstellbaren Audiokompressoren, die hohe Eingangspegel oberhalb eines Schwellenwertes ihres jeweiligen Frequenzbandes auf ein Maximum begrenzen und geringere Eingangspegel unterhalb des Schwellenwertes ihres jeweiligen Frequenzbandes individuell verstärken, dämpfen oder unverändert lassen; und
- Aufsummieren von Ausgangssignalen der Audiokompressoren, wobei ein Ausgangssignal mit verbesserter Sprachverständlichkeit erzeugt wird, wobei ein Parameter eine Gesamtlautstärke des Ausgangssignals steuert, und der zweite Parameter die Verbesserung der Sprachverständlichkeit steuert, indem zur Verbesserung der Sprachverständlichkeit durch Anstieg des zweiten Parameters bei dem Audiokompressor für hohe Frequenzen ein Verstärkungsgrad für Audiosignale mit geringem Lautstärkepegel stärker erhöht wird als ein Verstärkungsgrad für Audiosignale mit mittlerem oder hohem Lautstärkepegel, **dadurch gekennzeichnet, dass** zusätzlich eine Verstärkung des Audiokompressors für tiefe Frequenzen reduziert wird, so dass mit Anstieg des zweiten Parameters die tiefen Frequenzen zunehmend gedämpft werden.

9. Verfahren nach Anspruch 8 mit den weiteren vorgeschalteten Schritten
- Speichern von Parametern, die über die Nutzerschnittstelle für ein bekanntes Kontrollsignal eingestellt wurden, für das Energieinhalte definierter Frequenzbänder bekannt sind;
- Analysieren eines Eingangssignals, wobei Energieinhalte der definierten Frequenzbänder des Eingangssignals bestimmt werden; und
- Anpassen des Eingangssignals durch adaptives Verstärken oder Dämpfen der definierten Frequenzbänder entsprechend dem Kontrollsignal, wobei eine Verbesserung der Sprachverständlichkeit des Eingangssignals erreicht wird.

10. Verfahren gemäß Anspruch 8 oder 9 mit dem weiteren Schritt
- Filtern des Eingangssignals mit einem vorgeschalteten einstellbaren Equalizer (37), der ebenfalls über den zweiten Parameter gesteuert wird und mit dem im Bereich von ca. 500 - 6000 Hz schmale Frequenzbänder gezielt um bis zu 3 dB verstärkt oder gedämpft werden können, wobei zur Verbesserung der Sprachverständlichkeit Frequenzbänder im Bereich bis 500 Hz gedämpft und Frequenzbänder im Bereich 700 - 800 Hz besonders verstärkt werden.

11. Verfahren gemäß einem der Ansprüche 8 bis 10, wobei die Nutzerschnittstelle ein 2-dimensionales Bedienfeld (21) umfasst, dessen Achsen die zwei unabhängig einstellbaren Parameter sind, und wobei die zwei unabhängig einstellbaren Parameter gleichzeitig verändert werden können.

12. Computerprogrammprodukt mit computerlesbaren Instruktionen für eine computerimplementierte Ausführung des Verfahrens nach einem der Ansprüche 8-11.

13. Empfangsterminal, insbesondere Smartphone, mit einer Vorrichtung (86 - 88) zur Verarbeitung von Audiosignalen nach einem der Ansprüche 1 bis 7.

14. Empfangsterminal nach Anspruch 13, wobei das Empfangsterminal ein Mikrofon hat und über das Mikrofon aufgenommene Audiodaten über ein Drahtlosnetzwerk (82) an ein Audiostreaming-System senden kann, so dass das Empfangsterminal als eine Audioquelle des Audiostreaming-Systems dienen kann.

## Claims

1. Device for processing audio signals for reproduction via headphone or earphones with adjustable improvement of intelligibility of speech, comprising
- a filter bank (31) for splitting an input audio signal (In) into at least three frequency bands, with a frequency band respectively for signal components of low, medium and high audible frequencies;
- at least three individually adjustable audio compressors (33L, 33M, 33H) that are connected with the filter bank so as to process one of the signal components of the filter bank each, wherein high input levels above a threshold of their respective frequency band are limited to a maximum;
- a summation unit (35) for summing up output signals of the audio compressors (33L, 33M, 33H), wherein an output signal (Out) with improved speech intelligibility is generated; and
- a user interface with at least two independently adjustable parameters,
wherein one parameter controls an overall volume of the output signal and the second parameter controls the improvement of speech intelligibility, wherein for improving the speech intelligibility by an increase of the second parameter a gain level of the audio compressor for high frequencies (33H) for audio signals with low volume level is increased more than a gain level for audio signals with medium or high volume level,
**characterized in that**
additionally, a gain level of the audio compressor for low frequencies (33L) is reduced, such that with an increase of the second parameter the low frequencies are increasingly attenuated.

2. The device according to claim 1, wherein the second parameter selects for each of the compressors one from a plurality of characteristic compressor curves, which mainly differ in their gain for audio signals with low level.

3. The device according to claim 1 or 2, wherein a transition from the low to the medium audible frequencies is in the range of 600 - 1000 Hz and a transition from the medium to the high audible frequencies is in the range of 3000 - 5000 Hz.

4. The device according to claim 3, wherein the transition from the low to the medium audible frequencies is in the range of 900 Hz and the transition from the medium to the high audible frequencies is in the range of 3500 Hz.

5. The device according to one of the claims 1 through 4, wherein the user interface comprises a 2-dimensional control panel (21) whose axes are the two independently adjustable parameters.

6. The device according to one of the claims 1 through 5, further comprising
- a memory for storing parameters that have been set for a known control signal for which the energy contents of defined frequency bands are known;
- an analysis block for analysing an input signal, wherein energy contents of the defined frequency bands of the input signal are determined; and
- an equalizer for adapting the input signal by adaptive amplification or attenuation of the defined frequency bands corresponding to the control signal, wherein the adapted input signal is provided to the filter bank for splitting the input audio signal into at least three frequency bands.

7. The device according to one of the claims 1 through 6, further comprising an upstream adjustable equalizer (37), which is also controlled by the second parameter and by which narrow frequency bands in the range of about 500 - 6000 Hz can be selectively amplified or attenuated by up to 3 dB, wherein for improving the speech intelligibility frequency bands in the range of up to 500 Hz are attenuated and frequency bands in the range of 700 - 800 Hz are particularly amplified.

8. Method for processing audio signals for reproduction via headphone or earphones with adjustable improvement of intelligibility of speech, comprising steps of
- receiving at least two independently adjustable parameters from a user interface;
- splitting an input audio signal into at least three frequency bands using a filter bank, wherein a first frequency band contains signal components of low frequencies, a second frequency band contains signal components of medium frequencies and a third frequency band contains signal components of high frequencies;
- correcting the levels of each frequency band using at least three individually adjustable audio compressors that limit high input levels above a threshold of their respective frequency band to a maximum and that individually amplify, attenuate or keep lower input levels below the threshold of their respective frequency band; and
- summing up output signals of the audio compressors, wherein an output signal with improved speech intelligibility is generated,
wherein a parameter controls an overall volume of the output signal and the second parameter controls the improvement of speech intelligibility, wherein for improving the speech intelligibility by an increase of the second parameter a gain level of the audio compressor for high frequencies for audio signals with low volume level is increased more than a gain level for audio signals with medium or high volume level,
**characterized in that**
additionally, a gain level of the audio compressor for low frequencies is reduced, such that with an increase of the second parameter the low frequencies are increasingly attenuated.

9. Method according to claim 8 with the further upstream steps
- storing parameters that have been set through the user interface for a known control signal for which the energy contents of defined frequency bands are known;
- analysing an input signal, wherein energy contents of the defined frequency bands of the input signal are determined; and
- adapting the input signal by adaptive amplification or attenuation of the defined frequency bands corresponding to the control signal, wherein an improvement in speech intelligibility of the input signal is effected.

10. Method according to claim 8 or 9 with the further step
- filtering the input signal with an upstream adjustable equalizer (37), which is also controlled by the second parameter and by which narrow frequency bands in the range of about 500 - 6000 Hz can be selectively amplified or attenuated by up to 3 dB, wherein for improving the speech intelligibility frequency bands in the range of up to 500 Hz are attenuated and frequency bands in the range of 700 - 800 Hz are particularly amplified.

11. Method according to one of the claims 8 through 10, wherein the user interface comprises a 2-dimensional control panel (21) whose axes are the two independently adjustable parameters, and wherein the two independently adjustable parameters can be modified simultaneously.

12. Computer program product with computer readable instructions for computer implemented execution of the method according to one of the claims 8-11.

13. Reception terminal, in particular smartphone, with a device (86-88) for processing audio signals according to any one of the claims 1 through 7.

14. Reception terminal according to claim 13, wherein the reception terminal has a microphone and can transmit audio data recorded via the microphone through a wireless network (82) to an audio streaming system, such that the reception terminal may serve as an audio source of the audio streaming system.

## Revendications

1. Dispositif de traitement de signaux audio avec amélioration réglable de l'intelligibilité de la parole pour la reproduction via un casque ou un écouteur, contenant
- une banque de filtres (31) pour diviser un signal audio d'entrée (In) en au moins trois bandes de fréquences, avec une bande de fréquences pour des composantes de signal de fréquences audible basses, moyennes et hautes;
- au moins trois compresseurs audio à réglage individuel (33L, 33M, 33H) qui sont connectés à la banque de filtres afin de traiter l'une des composantes de signal du banque de filtres chacun, où des niveaux d'entrées élevés au-dessus d'une valeur seuil de leur bande de fréquence respective sont limités à un maximum;
- une unité de sommation (35) pour sommer les signaux de sortie des compresseurs audio (33L, 33M, 33H), un signal de sortie (Out) ayant une intelligibilité de la parole améliorée étant généré; et
- une interface utilisateur avec au moins deux paramètres réglables indépendamment, un paramètre contrôlant un volume global du signal de sortie et le deuxième paramètre contrôlant l'amélioration de l'intelligibilité de la parole en augmentant le niveau de gain du compresseur audio pour des fréquences hautes (33H) des signaux audio à faible volume plus qu'un niveau de gain des signaux audio à medium volume ou à haute volume, pour améliorer l'intelligibilité de la parole en augmentant le deuxième paramètre,
**caractérisé en ce que**
de plus, une amplification du compresseur audio pour des fréquences basses (33L) est réduite, de sorte qu'avec une augmentation du deuxième paramètre, les basses fréquences deviennent de plus en plus atténuées.

2. Dispositif selon la revendication 1, dans lequel pour chacun des compresseurs le deuxième paramètre sélectionne une parmi plusieurs courbes caractéristiques compresseurs qui diffèrent les uns des autres principalement dans l'amplification des signaux audio avec un faible niveau.

3. Dispositif selon la revendication 1 ou 2, dans lequel une transition de fréquences audibles basses à moyenne se situe dans la région de 600 - 1000 Hz, et une transition de fréquences audibles moyennes à hautes se situe dans la région de 3000 - 5000 Hz.

4. Dispositif selon la revendication 3, dans lequel la transition de fréquences audibles basses à moyenne se situe dans la région de 900 Hz, et une transition de fréquences audibles moyennes à hautes se situe dans la région de 3500 Hz.

5. Dispositif selon l'une des revendications 1 à 4, dans lequel l'interface utilisateur contient un panneau de contrôle bidimensionnel (21) dont les axes sont les deux paramètres réglables indépendamment.

6. Dispositif selon l'une des revendications 1 à 5, comprenant en outre
- une mémoire pour stocker des paramètres qui ont été ajustées pour un signal de commande connu pour lequel le contenu énergétique des bandes de fréquences définies est connu;
- un bloc d'analyse pour analyser un signal d'entrée, le contenu énergétique des bandes de fréquences définies du signal d'entrée étant déterminé; et
- un égalisateur pour adapter le signal d'entrée en amplifiant ou atténuant de manière adaptive les bandes de fréquences définies en fonction du signal de commande, le signal d'entrée adapté étant appliqué à la banque de filtres pour diviser un signal audio d'entrée en au moins trois bandes de fréquences.

7. Dispositif selon l'une des revendications 1 à 6, comprenant en outre un égalisateur réglable en amont (37), qui est également contrôlé par le deuxième paramètre et avec lequel des bandes de fréquences étroites dans la plage d'environ 500 à 6000 Hz peuvent être spécifiquement amplifiées ou atténuée jusqu'à 3 dB, des bandes de fréquences dans la plage allant jusqu'à 500 Hz étant atténuées et des bandes des fréquences dans la plage 700 - 800 Hz étant particulièrement amplifiées pour améliorer l'intelligibilité de la parole.

8. Procédé de traitement de signaux audio avec amélioration réglable de l'intelligibilité de la parole pour la reproduction via un casque ou un écouteur, comprenant les étapes
- recevoir d'un interface utilisateur au moins deux paramètres réglables indépendamment;
- diviser avec un banque de filtres un signal audio d'entrée en au moins trois bandes de fréquences, une première bande de fréquences comprenant des composantes de signal de fréquences basses, une deuxième bande de fréquences comprenant des composantes de signal de fréquences moyennes et une troisième bande de fréquences comprenant des composantes de signal de fréquences hautes;
- corriger les niveaux des bandes de fréquences avec au moins trois compresseurs audio à réglage individuel, qui limitent les niveaux d'entrée élevés au-dessus d'une valeur seuil de leur bande de fréquence à un maximum et qui amplifient, atténuent ou laissent inchangé de faibles niveaux d'entrée en dessous du valeur seuil de leur bande de fréquence; et
- sommer des signaux de sortie des compresseurs audio, un signal de sortie ayant une intelligibilité de la parole améliorée étant généré,
un paramètre contrôlant un volume global du signal de sortie, et le deuxième paramètre contrôlant l'amélioration de l'intelligibilité de la parole en augmentant un niveau de gain du compresseur audio pour des fréquences hautes (33H) des signaux audio à faible volume plus qu'un niveau de gain des signaux audio à medium volume ou à haute volume, pour améliorer l'intelligibilité de la parole en augmentant le deuxième paramètre,
**caractérisé en ce que**
de plus, une amplification du compresseur audio pour des fréquences basses (33L) est réduite, de sorte qu'avec une augmentation du deuxième paramètre, les basses fréquences sont de plus en plus atténuées.

9. Procédé selon la revendication 8, comprenant en outre les étapes amont
- stocker des paramètres qui ont été ajustées via l'interface utilisateur pour un signal de commande connu pour lequel le contenu énergétique des bandes de fréquences définies est connu;
- analyser un signal d'entrée, le contenu énergétique des bandes de fréquences définies du signal d'entrée étant déterminé; et
- adapter le signal d'entrée en amplifiant ou atténuant de manière adaptive les bandes de fréquences définies en fonction du signal de commande, améliorant ainsi une intelligibilité de la parole du signal d'entrée.

10. Procédé selon la revendication 8 ou 9, comprenant en outre l'étape
- filtrage du signal d'entrée dans un égalisateur réglable en amont (37), qui est également contrôlé par le deuxième paramètre et avec lequel des bandes de fréquences étroites dans la plage d'environ 500 - 6000 Hz peuvent être spécifiquement amplifiées ou atténuée jusqu'à 3 dB, des bandes de fréquences dans la plage allant jusqu'à 500 Hz étant atténuées et des bandes des fréquences dans la plage 700 - 800 Hz étant particulièrement amplifiées pour améliorer l'intelligibilité de la parole.

11. Procédé selon l'une des revendications 8 à 10, l'interface utilisateur comprenant un panneau de contrôle bidimensionnel (21), dont les axes sont les deux paramètres réglables indépendamment, et les deux paramètres réglables indépendamment peuvent être modifiés en même temps.

12. Produit de programme d'ordinateur avec instructions lisibles par ordinateur pour une exécution mise en œuvre par ordinateur du procédé selon l'une des revendications 8-11.

13. Terminal de réception, notamment smartphone, contenant un dispositif (86-88) de traitement de signaux audio selon l'une des revendications 1 à 7.

14. Terminal de réception selon la revendication 13, dans lequel le terminal de réception comprend un microphone et peut envoyer des données audios enregistrées via le microphone a un système de streaming audio via un réseau sans fil (82), de sorte que le terminal de réception puisse servir de source audio du système de streaming audio.
